# EUROPÄISCHE PATENTSCHRIFT

(11) **EP 2 742 549 B1**
(45) Veröffentlichungstag und Bekanntmachung des Hinweises auf die Patenterteilung: **13.01.2016**
(21) Anmeldenummer: 12758748.3
(22) Anmeldetag: 08.08.2012
(51) Int. Cl.: H01M 2/10

(54) **BATTERIEGEHÄUSETEIL ZUR ABSCHIRMUNG ELEKTROMAGNETISCHER STRAHLUNG FÜR EIN BATTERIEGEHÄUSE EINER TRAKTIONSBATTERIE EINES ELEKTROFAHRZEUGS UND VERFAHREN ZUR HERSTEILUNG DES BATTERIEGEHÄUSETEILS**
BATTERY HOUSING PART FOR SHIELDING ELECTROMAGNETIC RADIATION FOR A BATTERY HOUSING OF A TRACTION BATTERY OF AN ELECTRIC VEHICLE AND METHOD FOR PRODUCING THE BATTERY HOUSING PART
PARTIE DE BOÎTIER D'ACCUMULATEUR DESTINÉE À INTERCEPTER LE RAYONNEMENT ÉLECTROMAGNÉTIQUE, POUR UN BOÎTIER D'ACCUMULATEUR D'UN ACCUMULATEUR DE TRACTION D'UN VÉHICULE ÉLECTRIQUE, AINSI QUE PROCÉDÉ DE FABRICATION DE LA PARTIE DE BOÎTIER D'ACCUMULATEUR

(30) Priorität: 09.08.2011 DE 102011052515
(43) Veröffentlichungstag der Anmeldung: 18.06.2014
(73) Patentinhaber: REHAU AG + Co, 95111 Rehau (DE)
(72) Erfinder: HOFMANN, Martin, 08527 Plauen (DE); MÜLLER, Claus, 95028 Hof (DE)
(86) Internationale Anmeldenummer: PCT/EP2012/003373
(87) Internationale Veröffentlichungsnummer: WO 2013/020700

(56) Entgegenhaltungen:
- EP-A1- 2 072 309
- DE-A1-102006 048 291
- DE-A1-102009 037 138
- JP-A- 2002 008 609
- US-A- 6 040 080

## Beschreibung

### Hintergrund der Erfindung

Die vorliegende Anmeldung betrifft ein Batteriegehäuseteil für ein Batteriegehäuse einer Traktionsbatterie eines Elektrofahrzeugs und ein Verfahren zur Herstellung eines Batteriegehäuseteils für ein Batteriegehäuse einer Traktionsbatterie eines Elektrofahrzeugs.

Batteriegehäuse für Traktionsbatterien bzw. Antriebsbatterien von Elektrofahrzeugen weisen meist wenigstens zwei miteinander verbundene Batteriegehäuseteile auf, die zusammen das Batteriegehäuse bilden. Bekannte Batteriegehäuseteile sind hierbei meist aus ebenen, gekanteten oder tiefgezogenen Metallblechen gebildet, welche meist aus Aluminium oder Stahl bestehen. Auch in einem Aluminium-Druckgussverfahren hergestellte Batteriegehäuseteile sind bekannt. Aus einem metallischen Material bestehende Batteriegehäuseteile bzw. Batteriegehäuse ermöglichen eine wirksame Abschirmung der Umgebung des Batteriegehäuseteils vor elektromagnetischer Strahlung der Traktionsbatterie und auch eine wirksame Abschirmung der Traktionsbatterie vor elektromagnetischer Strahlung, die von Strahlungsquellen in Umgebung der Traktionsbatterie stammt.

Es ist auch bekannt, Batteriegehäuseteile bzw. Batteriegehäuse aus einem Kunststoffmaterial zu verwenden. Diese lassen sich im Unterschied zu den aus einem metallischen Material bestehenden Batteriegehäuseteilen mit einem wesentlich geringeren Gewicht ausbilden. Die Gewichtseinsparung gegenüber metallischen Gehäuseteilen liegt hierbei typischerweise in der Größenordnung von ca. 50 %. Allerdings ermöglichen derartige Batteriegehäuseteile keine wirksame Abschirmung vor elektromagnetischer Strahlung.

Derartige Batteriegehäuseteile bzw. Batteriegehäuse aus einem Kunststoffmaterial sind in den Schriften JP 2002 008 609 A, DE 10 2009 037 138 A1, US 6 040 080 A, EP 2 072 309 A1 offenbart.

### Zugrundeliegende Aufgabe

Gegenüber den bekannten Batteriegehäuseteilen, ist es Aufgabe der Erfindung, ein alternatives Batteriegehäuseteil für ein Batteriegehäuse einer Traktionsbatterie anzugeben, das bei geringem Gewicht eine wirksame Abschirmung vor elektromagnetischer Strahlung ermöglicht.

### Erfindungsgemäße Lösung

Diese Aufgabe wird mit einem Verfahren zur Herstellung eines derartigen Batteriegehäuseteils mit den Merkmalen des Anspruchs 1 gelöst.

Das Batteriegehäuseteil weist einen Aufnahmekörper, in welchem die Traktionsbatterie aufnehmbar ist, und wenigstens ein flächiges Element aus einem elektrisch leitfähigen Material auf, wobei der Aufnahmekörper wenigstens teilweise oder zur Gänze aus einem thermoplastischen oder duroplastischen Kunststoffmaterial besteht, und wobei das flächige Element für die Abschirmung eines Umgebungsbereichs des Batteriegehäuseteils und/oder für die Abschirmung der Traktionsbatterie vor elektromagnetischer Strahlung vorgesehen ist. Das flächige Element besteht vorzugsweise wenigstens teilweise aus einem metallischen Material.

"Flächig" im Sinne der Erfindung bedeutet, dass das flächige Element aus einem elektrisch leitfähigen Material nicht nur eben oder plattenförmig ausgebildet sein kann, sondern auch gebogen oder ungleichmäßig geformt sein kann. Insbesondere kann das flächige Element z.B. eine Mehrzahl von wenigstens zwei aneinander angrenzenden ebenen bzw. plattenförmigen Abschnitten aufweisen.

Im Unterschied zu bekannten Batteriegehäuseteilen weist das Batteriegehäuseteil ein flächiges Element aus einem elektrisch leitfähigen Material auf.

Durch Vorsehen des flächigen Elements kann eine wirksame Abschirmung eines Umgebungsbereichs des Batteriegehäuseteils vor elektromagnetischer Strahlung der Traktionsbatterie und/oder auch eine wirksame Abschirmung der Traktionsbatterie vor elektromagnetischer Strahlung bereitgestellt werden, die von Strahlungsquellen in Umgebung der Traktionsbatterie stammt.

Eine wirksame Abschirmung von Umgebungsbereichen des Batteriegehäuseteils bzw. des Batteriegehäuses vor elektromagnetischer Strahlung der Traktionsbatterie kann vorteilhaft insbesondere eine empfindliche Steuerelektronik des Elektrofahrzeugs vor elektromagnetischer Strahlung schützen, die durch sich zeitlich ändernde Batterieströme bei Startvorgängen oder Stoppvorgängen oder großen Beschleunigungen beim Betrieb des Elektrofahrzeugs erzeugt wird. Der EMV-Schutz betrifft sowohl Einstrahlung durch äußere Störquellen als auch leitungsgebundene Einkopplungen, die durch die Leistungselektronik oder den DC/DC Wandlern verursacht werden.

Das flächige Element selbst kann vorteilhaft mit einem sehr geringen Gewicht ausgebildet werden, so dass das Batteriegehäuseteil, das ferner einen Aufnahmekörper aufweist, der wenigstens teilweise oder zur Gänze aus einem thermoplastischen oder duroplastischen Kunststoffmaterial besteht, insgesamt mit einem geringen Gewicht ausgebildet werden kann. Das Batteriegehäuseteil kann also vorteilhafterweise wesentlich leichter ausgeführt werden als bekannte Batteriegehäuseteile vergleichbarer Form, die aus einem metallischen Material bestehen.

Ein weiterer Vorteil des flächigen Elements besteht darin, dass insbesondere im Falle eines Kurzschlusses einer oder mehrerer Zellen der Traktionsbatterie, die mit einem Durchbrennen der Zelle bzw. der Zellen unter Flammenbildung einhergeht, die durch die Flammenbildung bzw. das Durchbrennen erzeugte Wärme schnell in das flächige Element abgeleitet werden kann. Auf diese Weise kann ein punktuelles Aufschmelzen von thermoplastischem Material des Aufnahmekörpers wirksam vermieden oder wesentlich reduziert oder verzögert werden, so dass insbesondere ein Entzünden bzw. Brennen des Batteriegehäuseteils bzw. des Aufnahmekörpers im Vergleich zu bekannten Lösungen, bei denen das bei denen das Batteriegehäuseteil aus Kunststoff besteht und kein flächiges Element vorgesehen ist, vermieden oder das Risiko hierfür deutlich reduziert werden kann.

Ein Kurzschluss einer Zelle einer Traktionsbatterie wird oft durch einen Fabrikationsfehler oder Materialfehler an der Zelle oder durch das Eindringen eines Fremdkörpers verursacht und lässt sich nie völlig ausschließen.

Insgesamt ist mit dem Einsatz eines Batteriegehäuseteils, welches eine wirksame Abschirmung vor elektromagnetischer Strahlung bei sehr geringem Gewicht ermöglicht, ferner auch kein oder nur ein sehr geringes Brandrisiko verbunden.

Bei einer bevorzugten Ausführungsform ist das flächige Element eine Metallfolie, die eine wirksame Abschirmung vor elektromagnetischer Strahlung in Verbindung mit einer sehr guten Wärmeabfuhr ermöglicht. Die Metallfolie kann hierbei bevorzugt eine Kupferfolie oder eine Aluminiumfolie oder eine Nickelfolie oder eine Silberfolie oder eine Goldfolie oder eine Folie aus einem Eisenbasiswerkstoff (z.B. eine rostfreie Stahllegierung) sein.

Bei einer weiteren bevorzugten Ausführungsform ist das flächige Element ein Vlies und/oder Gewebe und/oder polymeres Schaummaterial aus leitfähigem oder leitfähig beschichtetem Material. Das flächige Element kann ein Vlies und/oder Gewebe und/oder polymeres Schaummaterial mit einer zumindest bereichsweisen Metallisierung sein. Das flächige Element kann auch ein Vlies und/oder Gewebe und/oder polymeres Schaummaterial mit einer zumindest bereichsweisen Beschichtung auf Kohlenstoffbasis sein. Das Vlies und/oder Gewebe und/oder polymere Schaummaterial kann insbesondere ein PolyesterGewebe und/oder Polyester-Vlies und/oder Polyolefin-Schaummaterial sein. Als Werkstoff für eine Metallisierung eignen sich im Besonderen Kupfer, Nickel, Zinn, Silber, Gold, Kobalt oder Kombinationen der vorgenannten Werkstoffe. Das Vlies und/oder Gewebe und/oder polymere Schaummaterial kann in verschiedene (Metall-)Bäder und/oder Galvanobäder getaucht werden um die Metallisierung zu erreichen. Das Vlies und/oder Gewebe und/oder polymere Schaummaterial kann zur Anpassung der Flexibilität und/oder Abschirmwirkung gegenüber elektromagnetischer Strahlung unterschiedliche Dichten und/oder Webarten und/oder Porenverteilungen und Porengrößen aufweisen. Auch ist denkbar einen Lagenaufbau aus rein thermischem isolierendem Vlies und/oder Gewebe und/oder polymerem Schaummaterial und einem leitfähigen oder leitfähig beschichtetem Vlies und/oder Gewebe und/oder polymerem Schaummaterial für das flächige Element vorzusehen.

Bei einer weiteren bevorzugten Ausführungsform ist das flächige Element ein metallisches Netz bzw. in Form eines metallische Netzes ausgebildet. Ein metallisches Netz kann mit einem sehr geringen Gewicht ausgeführt werden und gleichzeitig eine wirksame Abschirmung elektromagnetischer Strahlung ermöglichen.

Besonders bevorzugt weist das metallische Netz eine Vielzahl von Maschen auf, wobei die Maschen von metallischen Netzfäden begrenzt werden, wobei jede Masche eine Maschenfläche mit einer Flächengröße aufweist, die innerhalb eines Bereichs von 0,0025 mm² bis 4 mm² liegt, und wobei die Dicke der Netzfäden innerhalb eines Bereichs von 0,05 mm bis 0,5 mm liegt. Ein derart ausgebildetes metallisches Netz ermöglicht vorteilhaft eine sehr wirksame Abschirmung vor elektromagnetischer Strahlung in einem Frequenzbereich bis ca. 3 GHz, so dass bei einem vorteilhaften sehr geringen Gewicht des metallischen Netzes zugleich eine sehr wirksame Abschirmung bis in hohe Frequenzbereiche möglich ist.

Das metallische Netz, welches insbesondere in Form eines Gewebes ausgebildet sein kann, kann bevorzugt aus Kupfer, Aluminium, Nickel, Silber, Gold oder einem Eisenbasiswerkstoff (z.B. einer rostfreien Stahllegierung) bestehen.

Bei einer praktischen Ausführungsform liegt das flächige Element wenigstens bereichsweise auf dem Aufnahmekörper flächig auf, wobei besonders bevorzugt, das flächige Element in Form einer Schicht ausgebildet ist, die auf dem Aufnahmekörper flächig aufliegt und stoffschlüssig mit dem Aufnahmekörper verbunden ist.

Mittels eines in Schichtform ausgebildeten flächigen Elements kann eine sehr wirksame Abschirmung vor elektromagnetischer Strahlung und auch eine sehr wirksame Wärmeabfuhr ermöglicht werden, die ein Brennen bzw. Entflammen des Aufnahmekörpers bzw. des Batteriegehäuseteils vermeiden kann, und zwar insbesondere im Falle eines Kurzschlusses einer oder mehrerer Zellen der Traktionsbatterie, die mit einem Durchbrennen der Zelle bzw. der Zellen unter Flammenbildung einhergeht.

Die Schicht ist bevorzugt mittels eines Sputterverfahrens, Lackierverfahrens und/oder Bedampfungsverfahrens aufgebracht. Diese Verfahren ermöglichen ein insbesondere für die Serienfertigung geeignetes praktisches Aufbringen einer Schicht, die sehr gleichmäßig ausgebildet ist bzw. eine im wesentlichen gleichbleibende Schichtdicke aufweist. Insbesondere kann die Schicht auch eine mittels eines galvanischen Verfahrens aufgebrachte Schicht sein. Insbesondere mit einem galvanischen Verfahren kann eine sehr gleichmäßig ausgebildete Schicht mit im wesentlichen gleichbleibender Schichtdicke aufgebracht werden. Sofern ein Lackierverfahren zum Einsatz kommt, kann die Schicht z.B. aus einem Kupferlack oder anderen elektrisch leitfähigen Lacken mit metallischen Beimengungen (z.B. Partikel, Flakes, Pulver) bestehen. Die Schicht kann auch durch ein Flammspritzverfahren aufgebracht sein.

Bei einer praktischen Ausführungsform weist der Aufnahmekörper wenigstens eine Wandung auf, wobei das flächige Element wenigstens teilweise in der Wandung aufgenommen ist. Dies hat den Vorteil, dass das flächige Element durch äußere Einwirkungen nicht beschädigt werden kann. Auf diese Weise kann die mögliche Einsatzdauer bzw. Lebensdauer des flächigen Elements - und mithin auch die mögliche Einsatzdauer des Batteriegehäuseteils - wesentlich erhöht werden.

Bei einer weiteren praktischen Ausführungsform besteht der Aufnahmekörper wenigstens teilweise oder zur Gänze aus einem mit Endlosfasern verstärkten thermoplastischen oder duroplastischen Kunststoffmaterial. Der Aufnahmekörper kann infolge des Vorsehens der Verstärkung durch die Endlosfasern vorteilhaft mit hoher Festigkeit und geringem Gewicht ausgebildet sein bzw. ausgebildet werden. Die Faserverstärkung wird vorzugsweise durch Mineralfasern, insbesondere Glasfasern, und/oder durch Karbonfasern, und/oder durch Aramidfasern und/oder durch polymere Fasern, und/oder durch synthetische Fasern und/oder aus Fasern von nachwachsenden Rohstoffen gebildet.

Sämtliche vorstehend genannten flächigen Elemente können elektrisch leitend mit dem Massepotential des Elektrofahrzeuges (z.B. mit der Karosserie bzw. dem Fahrzeugrahmen) verbunden sein. Die elektrisch leitende Verbindung ist vorzugsweise direkt über das flächige Element oder über ein metallisches Leiterband realisiert.

Die Anmeldung betrifft ferner ein Batteriegehäuse für eine Traktionsbatterie eines Elektrofahrzeugs umfassend wenigstens zwei erfindungsgemäße Batteriegehäuseteile, wobei die Aufnahmekörper der Batteriegehäuseteile miteinander verbunden sind. Die flächigen Elemente der Batteriegehäuseteile können elektrisch leitend miteinander verbunden sein oder können einen elektrischen Kontakt zueinander aufweisen.

Mit dem Einsatz dieses Batteriegehäuses, welches eine wirksame Abschirmung vor elektromagnetischer Strahlung bei sehr geringem Gewicht ermöglicht, ist zudem in vorteilhafter Weise kein oder nur ein sehr geringes Brandrisiko verbunden, insbesondere auch dann, wenn es während des Betriebs des Elektrofahrzeugs zu einem Kurzschluss einer oder mehrerer Zellen der Traktionsbatterie kommt, die mit einem Durchbrennen der Zelle bzw. der Zellen unter Flammenbildung einhergeht. Die Verbindung der Aufnahmekörper kann bevorzugt in Form einer formschlüssigen Verbindung, insbesondere in Form einer Rastverbindung bzw. Schnappverbindung ausgebildet sein. Die Verbindung kann auch durch eine Schraubverbindung und/oder Klebeverbindung realisiert sein.

Ein Elektrofahrzeug im Rahmen dieser Erfindung umfasst auch sogenannte Hybridfahrzeuge bei denen neben einem Elektromotor auch ein Verbrennungsmotor Antriebsleistung bzw. Antriebsenergie bereitstellt.

Das erfindungsgemäße Verfahren zur Herstellung eines Batteriegehäuseteils für ein Batteriegehäuse einer Traktionsbatterie eines Elektrofahrzeugs gemäß Anspruch 1, umfasst die folgenden Schritte:
(A) Bereitstellen von im wesentlichen flächig ausgebildeten, faserverstärkten Matten mit einer die Fasern zumindest teilweise umgebenden thermoplastischen Matrix und Bereitstellen wenigstens eines flächigen Elements, das aus einem elektrisch leitfähigen Material besteht und plastisch verformbar ist,
(B) Auflegen des flächigen Elements auf eine erste Matten-Anordnung,
(C) Auflegen einer zweiten Matten-Anordnung auf das flächige Element,
(D) Erwärmen der thermoplastischen Matrix der Matten der ersten und/oder der zweiten Matten-Anordnung bis an oder bis über die Schmelztemperatur,
(E) Ausbilden des Batteriegehäuseteils durch plastisches Verformen und/oder Konsolidieren der Matten-Anordnungen und des flächigen Elements und
(F) Abkühlen des Batteriegehäuseteils.

Durch das erfindungsgemäße Verfahren gemäß Anspruch 1 kann auf praktische Weise unter Verwendung der flächig ausgebildeten, faserverstärkten Matten und dem wenigstens einen flächigen Element ein erfindungsgemäßes Batteriegehäuseteil hergestellt werden, bei welchem das flächige Element in wenigstens einer Wandung des Aufnahmekörpers wenigstens teilweise oder zur Gänze aufgenommen ist. Das flächige Element kann hierbei bevorzugt in Form einer Metallfolie oder in Form eines metallischen Netzes ausgebildet sein, einhergehend mit den bereits oben dargelegten Wirkungen und Vorteilen.

Das in Schritt A bereitgestellte flächige Element kann vorzugsweise wenigstens einen mit einem Haftvermittler beschichteten Bereich bzw. Oberflächenbereich aufweisen, wobei der Haftvermittler insbesondere in Form eines Klebers ausgebildet sein kann. Durch den Haftvermittler kann eine feste stoffschlüssige Aufnahme in der Wandung des Aufnahmekörpers des fertigen Batteriegehäuseteils - der gemäß dem erfindungsgemäßen Verfahren durch plastisches Verformen und/oder Konsolidieren der Matten-Anordnungen gebildet wird, bereitgestellt werden. Als Haftvermittler kann das flächige Element auch eine Kunststoffbeschichtung aufweisen, die eine Verträglichkeit zu der thermoplastischen Matrix der Matten bzw. Matten-Anordnungen aufweist.

Das Verfahren ist insbesondere für die Herstellung einer großen Vielzahl von Batteriegehäuseteilen, z.B. im Rahmen einer Serienfertigung von Vorteil. Sämtliche Verfahrensschritte können bevorzugt von wenigstens einem computergesteuerten Industrieroboter vorgenommen werden. Insbesondere die Schritte B bis E können von Industrierobotern bzw. Roboterarmen vorgenommen werden.

Die Ausbildung des Batteriegehäuseteils bzw. die endgültige Ausbildung des Batteriegehäuseteils erfolgt in Schritt E durch plastisches Verformen und/oder Konsolidieren der Matten-Anordnungen und des flächigen Elements, wobei durch plastisches Verformen und/oder Konsolidieren der Matten-Anordnungen insbesondere der Aufnahmekörper des erfindungsgemäßen Batteriegehäuseteils herstellbar ist.

Unter Konsolidieren ist erfindungsgemäß ein Verdichten bzw. Kompaktieren der faserverstärkten Matten zu verstehen. Beim dem Konsolidieren kann durch das Verdichten bzw. Kompaktieren insbesondere in den Matten aufgenommene Luft aus den Matten entweichen.

Erfindungsgemäß ist in Schritt E insbesondere auch vorgesehen, dass durch plastisches Verformen der Matten-Anordnungen eine Ausbildung bzw. eine endgültige Ausbildung des Batteriegehäuseteils erfolgt, wobei dies insbesondere auch durch das plastische Verformen in Verbindung mit einem Konsolidieren erfolgen kann.

Durch das Erwärmen der thermoplastischen Matrix der Matten der ersten und/oder der zweiten Matten-Anordnung bis an oder bis über die Schmelztemperatur in Schritt D kann die thermoplastische Matrix wenigstens teilweise oder zur Gänze in einem plastisch verformbaren Zustand überführt werden, der für die in Schritt E vorzunehmende Ausbildung des Batteriegehäuseteils durch plastisches Verformen und/oder durch Konsolidieren der ersten und der zweiten Matten-Anordnung benötigt wird. Vorzugsweise erfolgt durch das plastische Verformen und /oder Konsolidieren wenigstens bereichsweise die Ausbildung von einer oder mehreren stoffschlüssigen Verbindungen zwischen den Matten.

Die Erwärmung der thermoplastischen Matrix erfolgt vorzugsweise durch Konvektionserwärmung und/oder Infrarotstrahlung. Weiter vorzugsweise innerhalb eines Konvektions- und/oder Infrarot-Durchlaufofens. Die Erwärmung durch Infrarotstrahlung oder durch Konvektionserwärmung ermöglicht eine gleichmäßige Erwärmung der ersten und der zweiten Matten-Anordnung.

Die erste Matten-Anordnung kann eine faserverstärkte Matte oder eine Mehrzahl von faserverstärkten Matten umfassen und auch die zweite Matten-Anordnung kann eine faserverstärkte Matte oder eine Mehrzahl von faserverstärkten Matten umfassen, wobei in Schritt B die erste Matten-Anordnung vorzugsweise durch Aufeinanderlegen und/oder aneinander Anlegen und/oder nebeneinanderlegen der Mehrzahl der Matten gebildet wird, und wobei in Schritt C die zweite Matten-Anordnung vorzugsweise durch Aufeinanderlegen und/oder aneinander Anlegen und/oder nebeneinanderlegen der Mehrzahl der Matten gebildet wird.

Bei den im wesentlichen flächig ausgebildeten, faserverstärkten Matten handelt es sich vorzugsweise um zugeschnittene Matten bzw. Materialstücke mit einer die Fasern zumindest teilweise umgebenden thermoplastischen Matrix.

Die Faserverstärkung der Matten wird vorzugsweise durch Mineralfasern, insbesondere Glasfasern, und/oder durch Karbonfasern, und/oder durch Aramidfasern und/oder durch polymere Fasern, und/oder durch synthetische Fasern und/oder aus Fasern von nachwachsenden Rohstoffen gebildet.

Bei einer praktischen Ausführungsform werden in Schritt B und C die Matten-Anordnungen und das flächige Element auf einem die Grobkontur des Batteriegehäuseteils vorgebenden Werkstückträger aufgelegt und zu einem dreidimensionalen Vorformling aufgebaut, wobei während oder nach Abschluss des Aufbaus des Vorformlings eine Lagefixierung von wenigstens zwei Matten zueinander vorgenommen wird und wobei nach der Lagefixierung und nach Schritt D der Vorformling in ein die endgültige Form des Batteriegehäuseteils formendes Formwerkzeug gebracht und in Schritt E durch Bereitstellen eines Formwerkzeuginnendrucks aus dem Vorformling das Batteriegehäuseteil durch plastisches Verformen des Vorformlings und/oder durch Konsolidieren des Vorformlings gebildet wird.

Die Einbeziehung des die Grobkontur vorgebenden Werkzeugträgers ermöglicht auf praktische Weise eine präzise Herstellung eines Batteriegehäuseteils. Insbesondere ist durch das Vorsehen des Werkstückträgers vorteilhaft eine präzise Herstellung einer Vielzahl baugleicher bzw. im wesentlichen baugleicher Batteriegehäuseteile z.B. im Rahmen einer Serienfertigung möglich.

Durch das Vorformen bzw. Aufbauen der faserverstärkten Matten zu einem Vorformling kann je nach Anwendungsfall von einem stark ausgeprägtem plastischen Verformen abgesehen werden, so dass keine wesentlichen Umform- bzw. Fließvorgänge durchlaufen werden müssen. In diesem Fall kann gemäß Schritt E lediglich durch Konsolidieren die Ausbildung bzw. die endgültige Ausbildung des Batteriegehäuseteils erfolgen.

Bei dieser praktischen Ausführungsform des erfindungsgemäßen Verfahrens kann es sich bei den faserverstärkten Matten vorzugsweise um unidirektional-faserverstärkte Matten handeln. Hierbei erfolgt das Ausbilden des Vorformlings vorzugsweise derart, dass die Faserorientierung der Matten auf die im späteren Einsatz des Batteriegehäuseteils angreifenden Kräfte, und die daraus innerhalb des Batteriegehäuseteils resultierenden Lastpfade, abgestimmt wird.

Aufgrund der Abstimmung der Faserorientierung an dem dreidimensionalen Vorformling wird zudem erreicht, dass die an das hergestellte Batteriegehäuseteils angreifenden Kräfte, und die daraus innerhalb des Batteriegehäuseteils resultierenden Lastpfade, optimal durch die unidirektionale Faserverstärkung aufgenommen werden können. Durch diese Optimierung der Faserorientierung ist ein Batteriegehäuseteil mit sehr hoher Festigkeit herstellbar.

Die Bereitstellung des Formwerkzeuginnendrucks kann innerhalb des Formwerkzeugs durch Umspritzen des Vorformlings mit Kunststoff im Spritzgussverfahren erfolgen. Die Bereitstellung bzw. Einstellung des Formwerkzeuginnendrucks kann auch durch zusätzliches Einlegen von GMT-Stücken (GMT: Abk. für glasmattenverstärkter Thermoplast), weiter vorzugsweise durch eine Shot-Pot-Technik oder durch das Einlegen von Dichtschnüren in das Formwerkzeug oder durch das Einlegen einer Dichtfolie in das Formwerkzeug erfolgen. Weiterhin können die vorgenannten Möglichkeiten in beliebiger Kombination eingesetzt werden.

Durch die Einstellung eines Formwerkzeuginnendrucks durch die vorgenannten Möglichkeiten wird erreicht, dass es zu keinen unkontrollierten Fließvorgängen des thermoplastischen Materials der Matten innerhalb des Formwerkzeugs kommt, die zu einer ungewollten Verlagerung des in die thermoplastische Matrix eingebetteten Fasermaterials führt. Zudem wird durch den Formwerkzeuginnendruck eine gleichmäßige Konsolidierung des Vorformlings erreicht.

Die vorgesehene Lagefixierung von wenigstens zwei der Matten, wobei vorzugsweise eine Lagefixierung aller Matten zueinander erfolgt, kann z.B. unter Ausbildung wenigstens einer oder mehrerer stoffschlüssiger Verbindungen zwischen den Matten durch Verschweißen bzw. mittels eines Schweißverfahrens vorgenommen werden. Vorzugsweise erfolgt die Lagefixierung der Matten dabei durch ein Ultraschall- und/oder Heizelement- und/oder Laserschweißverfahren. Die Lagefixierung der Matten zueinander während oder nach Abschluss des Aufbaus bzw. der Ausbildung des Vorformlings bietet den Vorteil, dass der Vorformling eine deutlich verbesserte Handhabbarkeit aufweist. Zur Lagefixierung der Matten zueinander können zudem textiltechnische Verfahren, vorzugsweise Vernadeln und/oder Vernähen eingesetzt werden. Sofern die erste Matten-Anordnung und die zweite Matten-Anordnung jeweils eine Mehrzahl von faserverstärkten Matten umfassen erfolgt vorzugsweise eine Lagefixierung aller Matten der ersten Matten-Anordnung zueinander und ferner eine Lagefixierung aller Matten der zweiten Matten-Anordnung zueinander.

Bei einer weiteren praktischen Ausführungsform wird in Schritt E das Batteriegehäuseteil durch Tiefziehen der Matten-Anordnungen (bzw. der Matten der Matten-Anordnungen) und des flächigen Elements gebildet. Auch durch ein Tiefziehverfahren kann auf praktische und einfache Weise eine Ausbildung des Batteriegehäuseteils vorgenommen werden, insbesondere wenn die Bauform des Batteriegehäuseteils eine für das Tiefziehverfahren besondere geeignete Bauform ist.

Ein alternatives Verfahren zur Herstellung eines Batteriegehäuseteils für ein Batteriegehäuse einer Traktionsbatterie eines Elektrofahrzeugs, umfasst die folgenden Schritte:
(A-2) Bereitstellen von im wesentlichen flächig ausgebildeten, faserverstärkten Matten mit einer die Fasern zumindest teilweise umgebenden duroplastischen Matrix und Bereitstellen wenigstens eines flächigen Elements, das aus einem elektrisch leitfähigen Material besteht und plastisch verformbar ist,
(B-2) Auflegen des flächigen Elements auf eine erste Matten-Anordnung,
(C-2) Auflegen einer zweiten Matten-Anordnung auf das flächige Element,
(D-2) Ausbilden des Batteriegehäuseteils durch plastisches Verformen und/oder Konsolidieren der Matten-Anordnungen und des flächigen Elements, und
(E-2) Aushärten der duroplastischen Matrix und gegebenenfalls Abkühlen des Batteriegehäuseteils.

Das in Schritt A-2 bereitgestellte flächige Element kann vorzugsweise wenigstens einen mit einem Haftvermittler beschichteten Bereich bzw. Oberflächenbereich aufweisen, wobei der Haftvermittler insbesondere in Form eines Klebers ausgebildet sein kann. Durch den Haftvermittler kann eine feste stoffschlüssige Verbindung zwischen dem flächigen Element und der oder den Matten-Anordnung(en) realisiert werden. Als Haftvermittler kann das flächige Element auch eine Kunststoffbeschichtung aufweisen, die eine Verträglichkeit zu der duroplastischen Matrix der Matten bzw. Matten-Anordnungen aufweist.

Ein weiteres alternatives Verfahren zur Herstellung eines Batteriegehäuseteils für ein Batteriegehäuse einer Traktionsbatterie eines Elektrofahrzeugs, umfasst die folgenden Schritte:
(A-3) Bereitstellen einer aufgeschmolzenen oder zumindest fließfähigen langfaserverstärkten Thermoplast-Masse (LFT-Masse) und Bereitstellen wenigstens eines flächigen Elements, das aus einem elektrisch leitfähigen Material besteht und plastisch verformbar ist,
(B-3) Bereitstellen eines mehrteiligen und offenbar, das Batteriegehäuseteil formenden, Formwerkzeug mit mindestens einem Aufnahmebereich für die LFT-Masse,
(C-3) Einlegen des flächigen Elements auf oder in den Aufnahmebereich,
(D-3) Einbringen der LFT-Masse auf oder in den Aufnahmebereich,
(E-3) Ausbilden des Batteriegehäuseteils durch Schließen des Formwerkzeugs und Verpressen der LFT-Masse, wobei die LFT-Masse sich mit dem flächigen Element verbindet,
(F-3) Abkühlen und Aushärten des Batteriegehäuseteils.

Insbesondere die Schritte C-3 und D-3 können in ihrer zeitlichen Reihenfolge variiert werden oder sogar gleichzeitig erfolgen. Denkbar ist zudem zunächst gemäß Schritt D-3 einen ersten Teil der LFT-Masse einzubringen, dann das flächige Element gemäß Schritt (C-3) einzubringen und dann gemäß Schritt D-3 einen zweiten Teil der LFT-Masse einzubringen.

Das in Schritt A-3 bereitgestellte flächige Element kann vorzugsweise wenigstens einen mit einem Haftvermittler beschichteten Bereich bzw. Oberflächenbereich aufweisen, wobei der Haftvermittler insbesondere in Form eines Klebers ausgebildet sein kann. Durch den Haftvermittler kann eine feste stoffschlüssige Verbindung zwischen dem flächigen Element und der LFT-Masse bzw. der ausgehärteten LFT-Masse realisiert werden. Als Haftvermittler kann das flächige Element auch eine Kunststoffbeschichtung aufweisen, die eine Verträglichkeit zu der LFT-Masse bzw. der ausgehärteten LFT-Masse aufweist.

Das Bereitstellen der aufgeschmolzenen oder zumindest fließfähigen langfaserverstärkten Thermoplast-Masse (LFT-Masse) in Schritt A-3 kann einer Schmelz- und Eintragsvorrichtung (bestehend aus z.B. einem Extruder und einer Handlingseinheit) realisiert werden. Zur Umsetzung dieses Verfahren eignet sich insbesondere eine in der Patentschrift CH 697 185 A5 dargelegte Anlage auf die hiermit Bezug genommen wird.

### Kurzbeschreibung der Zeichnungen

Nachfolgend wird ein Ausführungsbeispiel der Erfindung anhand der beigefügten Zeichnungen näher erläutert. Es zeigt:
- Fig. 1: eine dreidimensionale Darstellung eines erstens Ausführungsbeispiels eines Batteriegehäuseteils,
- Fig. 2: eine schematische Schnittdarstellung eines Bereichs einer Wandung eines Aufnahmekörpers eines zweitens Ausführungsbeispiels eines Batteriegehäuseteils,
- Fig. 3: eine schematische Schnittdarstellung eines Bereichs einer Wandung eines Aufnahmekörpers eines dritten Ausführungsbeispiels eines Batteriegehäuseteils,
- Fig. 4: eine sehr schematische Schnittdarstellung einer Gesamt-Anordnung aus Matten und Materialstücken und
- Fig. 5: eine sehr schematische Darstellung eines Ausführungsbeispiel eines flächigen Elements in Form eines metallischen Netzes.

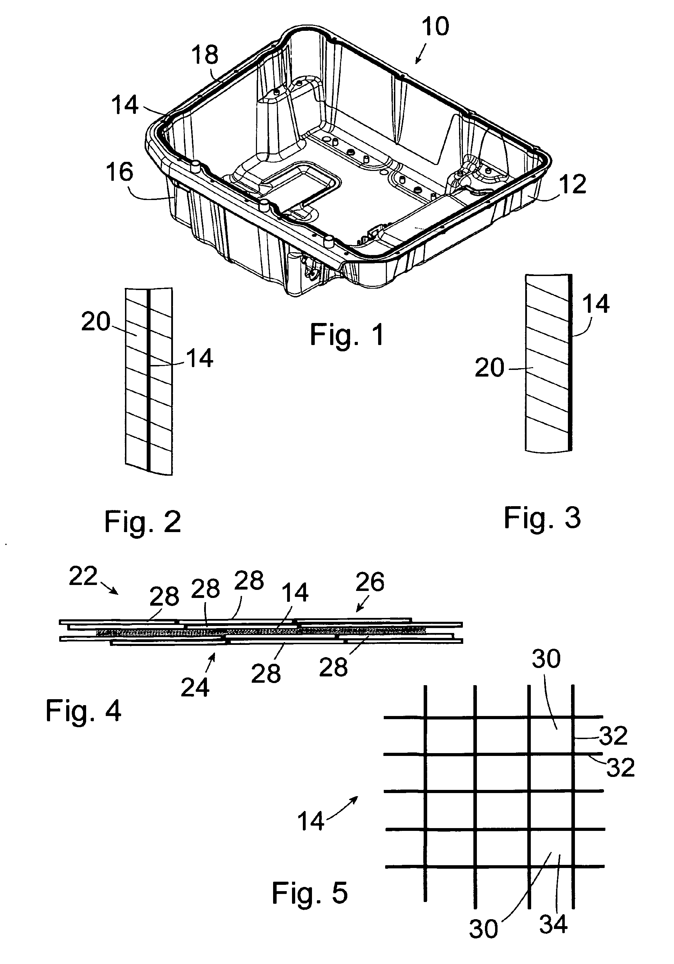

Das in der Fig. 1 dargestellte Batteriegehäuseteil 10 für ein Batteriegehäuse einer Traktionsbatterie eines Elektrofahrzeugs weist einen Aufnahmekörper 12 aus einem mit Endlosfasern verstärkten thermoplastischem (alternativ aus duroplastischem) Kunststoffmaterial auf. In dem Aufnahmekörper 12 ist eine Traktionsbatterie aufnehmbar (hier nicht dargestellt). Ferner weist das Batteriegehäuseteil 10 ein flächiges Element 14 aus einem elektrisch leitfähigen Material in Form einer Metallfolie 14 auf, die teilweise in einer umlaufenden Seitenwandung 16 des Aufnahmekörpers 12 aufgenommen ist.

Von der Metallfolie 14 ist in Fig. 1 nur ein umlaufender Randabschnitt 18 sichtbar. Die übrigen Bereiche der Metallfolie 14 sind in der Seitenwandung 16 aufgenommen. Der Randabschnitt 18 ermöglicht die Herstellung eines elektrischen Kontakts zu einem anderen freien umlaufenden Randabschnitt einer anderen Metallfolie, die teilweise in einer Seitenwandung eines Aufnahmekörpers eines anderen Batteriegehäuseteils (hier nicht dargestellt) aufgenommen ist. Die Aufnahmekörper der beiden Batteriegehäuseteile.können zur Bildung eines erfindungsgemäßen Batteriegehäuses unter Ausbilden eines elektrischen Kontakts der umlaufenden Randabschnitte miteinander verbunden werden. Die elektrisch kontaktierten Metallfolien können an der Karosserie und/oder dem Fahrzeugrahmen geerdet werden.

Die Fig. 2 zeigt eine schematische Schnittdarstellung eines Bereichs einer Wandung 20 eines Aufnahmekörpers eines zweitens Ausführungsbeispiels des erfindungsgemäßen Batteriegehäuseteils. Auch bei diesem Aufnahmekörper ist ein flächiges Element in Form einer Metallfolie 14 in der Wandung 20 teilweise aufgenommen.

Bei dem in der Fig. 3 schematisch veranschaulichten Ausführungsbeispiel weist das Batteriegehäuseteil ein flächiges Element auf, dass in Form einer metallischen Schicht 14 ausgebildet ist, die auf der Wandung 20 bzw. dem Aufnahmekörper flächig aufliegt und mit der Wandung 20 bzw. dem Aufnahmekörper stoffschlüssig verbunden ist. Die Schicht 14 kann sehr dünn ausgeführt sein und z.B. eine Dicke in der Größenordnung von ca. 35 im aufweisen.

Bei einer weiteren Ausführungsform (hier nicht näher dargestellt) ist das flächige Element ein Vlies und/oder Gewebe aus leitfähigem oder leitfähig beschichtetem Material. Mit einem mit einer Kupfer-Nickel-Legierung metallisierten Vlies der Firma Micro Tech Components GmbH mit Artikelbezeichnung RGW-NW-50-PCN wurde in entsprechenden Versuchen eine hinreichende Abschirmung des Umgebungsbereichs des Batteriegehäuseteils 10 und eine hinreichende Abschirmung der Traktionsbatterie vor elektromagnetischer Strahlung erzielt.

Bei dem in der Fig. 1 dargestellten Batteriegehäuseteil 10 handelt es sich um ein durch das erfindungsgemäße Verfahren gemäß einem der Ansprüche 1 bis 7 hergestelltes Batteriegehäuseteil 10, wobei der Aufnahmekörper 12 aus den Matten der ersten und zweiten Matten-Anordnung durch plastisches Verformen und/oder Konsolidieren gebildet wurde.

Die Fig. 4 veranschaulicht in Schnittdarstellung sehr schematisch eine durch Vornehmen der Schritte A bis C des erfindungsgemäßen Verfahrens gemäß einem der Ansprüche 1 bis 7 gebildete Gesamt-Anordnung 22 umfassend eine erste Matten-Anordnung 24, eine zweite Matten-Anordnung 26 und ein flächiges Element 14 aus einem elektrisch leitfähigen Material. Aus der Gesamt-Anordnung 22 kann gemäß Schritt E des erfindungsgemäßen Verfahrens durch plastisches Verformen und/oder durch Konsolidieren der Matten 28 der ersten Matten-Anordnung 24 und der zweiten Matten-Anordnung 26 und des flächigen Elements 14 ein Batteriegehäuseteil gebildet werden.

Die Ausbildung der Gesamt-Anordnung 22 erfolgte durch Auflegen des flächigen Elements 14 auf die erste Matten-Anordnung 24 - die zuvor durch aufeinanderlegen und aneinander Anlegen einer ersten Mehrzahl von faserverstärkten Matten 28 gebildet wurde - und anschließendes Auflegen einer zweiten Mehrzahl von faserverstärkten Matten 28 auf das flächige Element 14 zur Bildung einer zweiten, auf das flächige Element 14 aufgelegten Matten-Anordnung 26, wobei die zweite Matten-Anordnung 26 durch aufeinanderlegen und aneinander Anlegen der zweiten Mehrzahl von faserverstärkten Matten 28 gebildet wurde.

Die Bildung des Batteriegehäuseteils in Schritt E - die insbesondere auch durch Tiefzeihen der Gesamt-Anordnung 22 umfassend die Matten-Anordnungen 24, 26 und das flächige Element 14 erfolgen kann - erfolgt nach dem Erwärmen der thermoplastischen Matrix der Matten 28 der Matten-Anordnungen 24, 26 gemäß Schritt D. Nach Schritt E erfolgt in Schritt F das Abkühlen des fertig geformten Batteriegehäuseteils.

Die Fig. 5 veranschaulicht schematisch ein Ausführungsbeispiel eines flächigen Elements 14 in Form eines metallischen Netzes 14, das eine Vielzahl von Maschen 30 aufweist, wobei die Maschen 30 von metallischen Netzfäden 32 begrenzt werden, wobei jede Masche 30 eine Maschenfläche 34 mit einer Flächengröße aufweist, die innerhalb eines Bereichs von 0,0025 mm² bis 4 mm² liegt, und wobei die Dicke der Netzfäden 32 innerhalb eines Bereichs von 0,05 mm bis 0,5 mm liegt (die Fig. 6 ist nur eine schematische Darstellung eines Netzes, an dem die hier definierten Flächenwerte und Dickenwerte nicht realisiert sind). Die Maschenfläche 34 muss nicht zwingend (wie in Fig. 5 dargestellt) quadratisch ausgebildet sein. Beispielhaft kann die Maschenfläche auch rechteckig, rautenförmig, dreieckig, oval, kreisförmig oder mehreckig ausgebildet sein.

### Bezugszeichenliste

- 10: Batteriegehäuseteil
- 12: Aufnahmekörper
- 14: flächiges Element
- 16: Seitenwandung
- 18: Randabschnitt
- 20: Wandung
- 22: Gesamt-Anordnung
- 24: erste Matten-Anordnung
- 26: zweite Matten-Anordnung
- 28: Matte
- 30: Masche
- 32: Netzfaden
- 34: Maschenfläche

## Patentansprüche

1. Verfahren zur Herstellung eines Batteriegehäuseteils (10) für ein Batteriegehäuse einer Traktionsbatterie eines Elektrofahrzeugs, umfassend die folgenden Schrittreihenfolge:
(A) Bereitstellen von im wesentlichen flächig ausgebildeten, faserverstärkten Matten (28) mit einer die Fasern zumindest teilweise umgebenden thermoplastischen Matrix und Bereitstellen wenigstens eines flächigen Elements (14), das aus einem elektrisch leitfähigen Material besteht und plastisch verformbar ist,
(B) Auflegen des flächigen Elements (14) auf eine erste Matten-Anordnung (24), wobei die erste Matten-Anordnung (24) eine faserverstärkte Matte (28) oder eine Mehrzahl von faserverstärkten Matten (28) umfasst,
(C) Auflegen einer zweiten Matten-Anordnung (26) auf das flächige Element (14), wobei die zweite Matten-Anordnung (26) eine faserverstärkte Matte (28) oder eine Mehrzahl von faserverstärkten Matten (28) umfasst,
(D) Erwärmen der thermoplastischen Matrix der Matten (28) der ersten und/oder der zweiten Matten-Anordnung (24, 26) bis an oder bis über die Schmelztemperatur,
(E) Ausbilden des Batteriegehäuseteils (10) durch plastisches Verformen und/oder Konsolidieren der Matten-Anordnungen (24, 26) und des flächigen Elements (14) und
(F) Abkühlen des Batteriegehäuseteils (10).

2. Verfahren nach Anspruch 1, **dadurch gekennzeichnet, dass** das flächige Element (14) in Form einer Metallfolie oder in Form eines metallischen Netzes ausgebildet ist.

3. Verfahren nach Anspruch 1 oder 2, **dadurch gekennzeichnet, dass** das flächige Element (14) wenigstens einen mit einem Haftvermittler beschichteten Bereich bzw. Oberflächenbereich aufweist.

4. Verfahren nach Anspruch 3, **dadurch gekennzeichnet, dass** das flächige Element (14) als Haftvermittler eine Kunststoffbeschichtung aufweist, die eine Verträglichkeit zu der thermoplastischen Matrix der Matten (28) bzw. Matten-Anordnungen (24, 26) aufweist.

5. Verfahren nach einem der vorangehenden Ansprüche, **dadurch gekennzeichnet, dass** in Schritt (B) die erste Matten-Anordnung (24) durch Aufeinanderlegen und/oder aneinander Anlegen und/oder nebeneinanderlegen der Mehrzahl der Matten (28) gebildet wird, und dass in Schritt (C) die zweite Matten-Anordnung (26) durch Aufeinanderlegen und/oder aneinander Anlegen und/oder nebeneinanderlegen der Mehrzahl der Matten (28) gebildet wird.

6. Verfahren nach einem der vorangehenden Ansprüche, **dadurch gekennzeichnet, dass** in Schritt (B) und ( C) die Matten-Anordnungen (24, 26) und das flächige Element (14) auf einem die Grobkontur des Batteriegehäuseteils (10) vorgebenden Werkstückträger aufgelegt und zu einem dreidimensionalen dem Vorformling aufgebaut werden, wobei während oder nach Abschluss des Aufbaus des Vorformlings eine Lagefixierung von wenigstens zwei Matten (28) zueinander vorgenommen wird und wobei nach der Lagefixierung und nach Schritt (D) der Vorformling in ein die endgültige Form des Batteriegehäuseteils (10) formendes Formwerkzeug gebracht und in Schritt (E) durch Bereitstellen eines Formwerkzeuginnendrucks aus dem Vorformling das Batteriegehäuseteil (10) durch plastisches Verformen des Vorformlings und /oder durch Konsolidieren des Vorformlings gebildet wird.

7. Verfahren nach einem der vorangehenden Ansprüche 1 bis 5, **dadurch gekennzeichnet, dass** in Schritt (E) das Batteriegehäuseteil (10) durch Tiefziehen der Matten-Anordnungen (24, 26) und des flächigen Elements (14) gebildet wird.

## Claims

1. Method for producing a battery housing part (10) for a battery housing of a traction battery of an electric vehicle, comprising the following series of steps:
(A) providing substantially flat-formed, fibre-reinforced mats (28) having a thermoplastic matrix that at least partially surrounds the fibres, and providing at least one flat element (14), which consists of an electrically conductive material and is plastically deformable,
(B) placing the flat element (14) onto a first mat arrangement (24), the first mat arrangement (24) comprising a fibre-reinforced mat (28) or a plurality of fibre-reinforced mats (28),
(C) placing a second mat arrangement (26) onto the flat element (14), the second mat arrangement (26) comprising a fibre-reinforced mat (28) or a plurality of fibre-reinforced mats (28),
(D) heating the thermoplastic matrix of the mats (28) of the first and/or second mat arrangement (24, 26) up to or to above the melting temperature,
(E) forming the battery housing part (10) by plastically deforming and/or consolidating the mat arrangements (24, 26) and the flat element (14) and
(F) cooling down the battery housing part (10).

2. Method according to Claim 1, **characterized in that** the flat element (14) takes the form of a metal foil or the form of a metal mesh.

3. Method according to Claim 1 or 2, **characterized in that** the flat element (14) has at least one region or surface region coated with an adhesion promoter.

4. Method according to Claim 3, **characterized in that** the flat element (14) has as an adhesion promoter a coating of plastic that is compatible with the thermoplastic matrix of the mats (28) or mat arrangements (24, 26).

5. Method according to one of the preceding claims, **characterized in that** in step (B) the first mat arrangement (24) is formed by placing the plurality of mats (28) one on top of the other and/or one against the other and/or one next to the other, and **in that** in step (C) the second mat arrangement (26) is formed by placing the plurality of mats (28) one on top of the other and/or one against the other and/or one next to the other.

6. Method according to one of the preceding claims, **characterized in that** in steps (B) and (C) the mat arrangements (24, 26) and the flat element (14) are placed on a workpiece carrier predefining the approximate contour of the battery housing part (10) and are built up to form a three-dimensional preform, a positional fixing of at least two mats (28) in relation to another being performed during or after completion of the build-up of the preform and, after the positional fixing and after step (D), the preform being brought into a moulding tool that moulds the final form of the battery housing part (10) and in step (E) the battery housing part (10) being formed from the preform by plastically deforming the preform and/or by consolidating the preform, by providing an internal moulding tool pressure.

7. Method according to one of the preceding Claims 1 to 5, **characterized in that** in step (E) the battery housing part (10) is formed by thermoforming the mat arrangements (24, 26) and the flat element (14).

## Revendications

1. Procédé de fabrication d'une pièce de boîtier de batterie (10) pour un boîtier de batterie d'une batterie de traction d'un véhicule électrique, comprenant la séquence d'étapes suivante :
(A) mise à disposition de nattes (28) renforcées par des fibres, de configuration sensiblement plate, avec une matrice thermoplastique qui entoure au moins partiellement les fibres et mise à disposition d'au moins un élément plat (14) qui se compose d'un matériau électriquement conducteur et facile à façonner,
(B) application de l'élément plat (14) sur un premier arrangement de nattes (24), le premier arrangement de nattes (24) comprenant une natte (28) renforcée par des fibres ou une pluralité de nattes (28) renforcées par des fibres,
(C) application d'un deuxième arrangement de nattes (26) sur l'élément plat (14), le deuxième arrangement de nattes (26) comprenant une natte (28) renforcée par des fibres ou une pluralité de nattes (28) renforcées par des fibres,
(D) échauffement de la matrice thermoplastique des nattes (28) du premier et/ou du deuxième arrangement de nattes (24, 26) jusqu'à ou au-dessus de la température de fusion,
(E) formation de la pièce de boîtier de batterie (10) par façonnage et/ou consolidation des arrangements de nattes (24, 26) et de l'élément plat (14) et
(F) refroidissement de la pièce de boîtier de batterie (10).

2. Procédé selon la revendication 1, **caractérisé en ce que** l'élément plat (14) est réalisé sous la forme d'un film métallique ou sous la forme d'une tresse métallique.

3. Procédé selon la revendication 1 ou 2, **caractérisé en ce que** l'élément plat (14) possède au moins une zone ou une zone de surface enduite d'un agent adhésif.

4. Procédé selon la revendication 3, **caractérisé en ce que** l'élément plat (14) possède comme agent adhésif un revêtement en matière plastique qui présente une compatibilité avec la matrice thermoplastique des nattes (28) ou des arrangements de nattes (24, 26).

5. Procédé selon l'une des revendications précédentes, **caractérisé en ce qu'**à l'étape (B), le premier arrangement de nattes (24) est formé par empilage et/ou aboutage et/ou juxtaposition de la pluralité de nattes (28), et **en ce qu'**à l'étape (C), le deuxième arrangement de nattes (26) est formé par empilage et/ou aboutage et/ou juxtaposition de la pluralité de nattes (28).

6. Procédé selon l'une des revendications précédentes, **caractérisé en ce qu'**aux étapes (B) et (C), les arrangements de nattes (24, 26) et l'élément plat (14) sont déposés sur un porte-pièce qui prédéfinit le contour approximatif de la pièce de boîtier de batterie (10) et agencés en une ébauche tridimensionnelle, un positionnement fixe d'au moins deux nattes (28) l'une par rapport à l'autre étant effectué pendant l'agencement de l'ébauche ou après avoir terminé celui-ci et après l'étape (D), l'ébauche étant amenée dans un outil de formage qui façonne la forme définitive de la pièce de boîtier de batterie (10) et à l'étape (E), la pièce de boîtier de batterie (10) étant formée à partir de l'ébauche par production d'une pression interne d'outil de formage par façonnage de l'ébauche et/ou par consolidation de l'ébauche.

7. Procédé selon l'une des revendications précédentes 1 à 5, **caractérisé en ce qu'**à l'étape (E), la pièce de boîtier de batterie (10) est formée par emboutissage des arrangements de nattes (24, 26) et de l'élément plat (14).
